# FASCICULE DE BREVET EUROPEEN

(11) **EP 0 419 369 B1**
(45) Date de publication et mention de la délivrance du brevet: **29.04.1998**
(21) Numéro de dépôt: 90402617.6
(22) Date de dépôt: 21.09.1990
(51) Int. Cl.: G03F 7/20, H01J 37/304

(54) **Procédé de microlithographie en champ proche optique et dispositifs de microlithographie le mettant en oeuvre**
Optisches Nahfeld-Verfahren für Mikrolithographie und Mikrolithographie-Vorrichtungen unter Verwendung desselben
Optical near-field method for microlithography and microlithography devices using this method

(30) Priorité: 22.09.1989 FR 8912497
(43) Date de publication de la demande: 27.03.1991
(73) Titulaire: SIM (SOCIETE D'INVESTISSEMENT DANS LA MICROSCOPIE) SA, 21160 Marsannay La Cote (FR)
(72) Inventeur: De Fornel, Frédérique, F-21000 Dijon (FR); Goudonnet, Jean-Pierre, F-21000 Dijon (FR); Mantovani, James, States Boro, GA 30458 (US)
(74) Mandataire: Serin, Jean-Pierre

(56) Documents cités:
- EP-A- 0 128 993
- EP-A- 0 283 256
- FR-A- 1 567 415
- US-A- 4 512 642
- PATENT ABSTRACTS OF JAPAN vol. 5, no. 167 (E-79)(839) 24 octobre 1981; & JP-A-56 94 742

## Description

L'invention concerne un procédé de microlithographie pour la réalisation de structures superficielles submicrométriques sur un substrat du type d'une plaquette de silicium, ainsi qu'un dispositif le mettant en oeuvre.

Le processus de fabrication des circuits intégrés, et notamment des circuits à très large intégration (également dénommés VLSI), comporte une succession d'étapes visant à obtenir des structures gravées complexes sur une plaquette de silicium, à savoir :
- oxydation superficielle du silicium pour obtenir une mince couche de silice,
- dépôt d'une couche d'un matériau sensible aux radiations, du type par exemple d'une lumière ultraviolette, d'un faisceau d'électrons ou d'un faisceau de rayons X,
- impression d'une image latente sur ce matériau par une technique de microlithographie, telle que par exemple la technique du masquage,
- amplification de cette image latente, par une méthode de développement appropriée, les zones de réserve délimitant le dessin à réaliser sur le silicium,
- stabilisation de cette image, par une méthode de fixage appropriée, ou une méthode de gravure, par exemple par plasma,
- irradiation ionique du silicium par les ouvertures obtenues dans la silice (pour obtenir des zones diversement dopées dans le silicium).

Toutes ces étapes du processus de fabrication peuvent être recommencées plusieurs fois, la microlithographie étant, chaque fois, l'étape décisive dans l'obtention de motifs submicrométriques avec un bon rendement.

Parmi les techniques connues de microlithographie, la plus utilisée est le photomasquage, ou impression par projection ; le concepteur du circuit intégré fait réaliser un ensemble de masques opaques qui serviront successivement à obtenir des motifs particuliers sur une résine photosensible (résine négative pour obtenir des dessins transparents, ou résine positive pour obtenir des dessins opaques). L'exposition se fait préférentiellement avec une lumière de courte longueur d'ondes du type d'une lumière ultraviolette. Le positionnement, ou le repositionnement, de masques opaques sur une plaquette de silicium est une opération délicate, leur alignement respectif devant être rigoureux. Par ailleurs, lors de l'exposition, le contact entre la résine et le masque doit être intime afin d'éviter tout ombrage, ce qui nécessite de contrôler avec précision les déformations dimensionnelles de la plaquette de silicium et du masque. Cette technique permet de réaliser sur des plaquettes de silicium des motifs dont la résolution est voisine de 0,5 micromètres, avec une résine photosensible positive (la résolution d'une résine négative étant bien plus médiocre).

Au-delà, c'est-à-dire s'il l'on veut obtenir des motifs de résolution plus faible, et essayer d'atteindre notamment la limite de 0,1 micromètres - qui est considérée comme étant la limite fixée par la physique des semi-conducteurs -, la longueur d'onde d'une lumière ultraviolette est trop grande. C'est pourquoi on a développé des techniques de microlithographie non optique, basée sur l'utilisation d'un faisceau d'électrons ou d'un faisceau de rayons X, balayant directement, ou "irradiant" à travers un masque approprié, une résine sensible à ces rayonnements. La meilleure résolution actuellement atteinte est proche de 0,3 micromètres.

Ces dernières techniques présentent néanmoins encore de graves inconvénients.

C'est notamment le cas pour la gravure directe d'une résine par un faisceau d'électrons monocinétiques d'énergie adéquate ; alors que cette technique ne nécessite de recourir à aucun masque, elle est limitée en résolution par des phénomènes secondaires souvent inacceptables. Il se produit, en effet, une émission d'électrons secondaires lorsque le faisceau d'électrons frappe la surface de la résine et celle du silicium ; la rétro-diffusion d'électrons qui en résulte tend, d'une part à épaissir les motifs gravés et plus particulièrement le tracé des lignes, d'autre part à élever le niveau d'exposition du fond de la couche de résine, et, en outre, à créer un effet de proximité entre motifs adjacents, nécessitant le calcul de facteurs correctifs lors de l'exposition. L'exposition dépend donc de l'épaisseur de la résine, selon des paramètres difficilement contrôlables.

La lithographie non optique par rayons X mous (énergie variant entre 280 et 1000 eV) est une technique par projection au travers de masques extrêmement fins, qui permettra sans doute d'atteindre une résolution ultime (0,1 micromètres). Cette technique ne possède pas les inconvénients précédemment mentionnés du dessin direct par faisceau d'électrons, mais il est nécessaire de ré-aligner les masques sur la plaquette de silicium à chaque étape du processus de fabrication des circuits intégrés, et le temps nécessaire à ces opérations peut être long.

On connaît enfin un procédé lithographique très récent, et n'ayant pas encore franchi l'étape de l'industrialisation pour des raisons qui vont être exposées. Ce procédé consiste à maintenir une source de rayonnement à une distance très faible de la surface de la plaquette à exposer ; pour ce faire, un capteur de proximité électronique, directement issu du microscope à effet tunnel électronique par balayage, est disposé à côté de la source de rayonnement. On sait qu'un tel capteur de proximité permet de maintenir des distances aussi faibles qu'une dizaine d'angstroems entre une pointe et une surface conductrices. A une telle distance, une source ponctuelle de rayonnement - il s'agit en général d'une source de rayonnement lumineux ultraviolet - émet un rayonnement très peu diffractant ; la microlithographie d'une résine est alors très précise et la résolution est notablement améliorée, sans avoir recours aux techniques utilisant de très courtes longueurs d'ondes (faisceaux d'électrons monocinétiques ou rayons X).

Ce procédé est cependant délicat à mettre en oeuvre, ceci pour plusieurs raisons :
- tout d'abord, la source de rayonnement et le capteur de proximité sont décalés l'un par rapport à l'autre ; on ne contrôle donc pas exactement la distance entre ladite source et la surface de la résine à exposer. Etant donnés l'ordre de grandeur de cette distance (quelques angstroems), ainsi que les irrégularités nanoscopiques de la surface, ce décalage peut provoquer la mise en contact de la source avec cette surface, conduisant à sa détérioration.
- ensuite, la nature électronique du capteur de proximité à effet tunnel utilisé rend nécessaire que la surface à maintenir à distance soit conductrice. Si on désire utiliser une résine sensible aux rayonnements optiques ("photoresist"), il faut prévoir de déposer une couche conductrice sur cette résine, ce qui est un inconvénient notable puisque cela complique le processus. Si on utilise, par contre, une résine sensible aux rayonnements non optiques ("electroresist"), la surface est conductrice mais il faut alors mettre en oeuvre une gravure électronique ou par rayons X. Or, les sources ponctuelles de rayons X, comme les sources d'électrons, nécessitent d'être polarisées électriquement par rapport à la surface à graver pour pouvoir fonctionner ; cette polarisation vient gêner, voire interdit, la mesure du courant de très faible intensité circulant entre la surface et le capteur électronique à effet tunnel.
- enfin, la nature chimique de la résine se modifie en cours de gravure. Comme le courant recueilli par le capteur à effet tunnel varie très sensiblement avec cette nature chimique, le contrôle de proximité ne peut plus être fiable.

On connaît également du Patent Absbracts of Japan vol. 5, n° 167 (E-79) (839) 24 ocbobre 1981 (et JP-A-56 94 742) un dispositif de microlithographie par un faisceau électronique. Ce dispositif comprend un capteur de proximité à guide d'ondes pour mesurer la variation, en fonction d'une distance du substrat, de l'intensité d'une onde électromagnétique réfléchie par ledit substrat dans la zone située à l'extrémité de ce capteur. Selon ce document, l'information reçue de ce capteur sert à contrôler le foyer du faisceau électronique pour régler celui-ci de sorte que la position du faisceau électronique formant image puisse coïncider avec la surface du substrat devant être traité.

Cependant, ce dispositif présente l'inconvénient que la source de rayonnement, c'est-à-dire le faisceau électronique, et le capteur de proximité sont décalés l'un par rapport à l'autre, ce qui a pour effet que le traitement n'a jamais lieu à l'endroit même de la mesure, ce qui entraîne une exposition imprécise.

La présente invention vise à remédier à ces inconvénients en proposant un procédé tel que défini dans la revendication 1 et un dispositif de mise en oeuvre de ce procédé, tel que défini dans la revendication 4. Le procédé et le dispositif sont davanbage précisés dans les revendications dépendantes.

Un capteur de proximité à guide d'ondes, du type préconisé dans l'invention, est notamment décrit dans la demande de brevet française n° 89.11297, déposée le 28 août 1989 au nom de la Demanderesse, sous le titre "microscope en champ proche en réflexion utilisant un guide d'ondes comme sonde de ce champ".

Un tel capteur est capable de mesurer la variation rapide de l'intensité d'une onde électromagnétique, émise à l'extrémité de la fibre et réfléchie en retour par le substrat, en fonction de ladite distance. Ce phénomène est sensible dans la zone dite de champ proche, située à proximité de l'extrémité de la fibre émettrice, c'est-à-dire pour des distances inférieures à une dizaine de longueur de l'onde électromagnétique servant à la mesure.

L'utilisation selon l'invention d'un capteur de proximité optique permet de s'affranchir des inconvénients des dispositifs de microlithographie connus à ce jour. Par ailleurs, la gravure de la résine peut s'effectuer de manière optique ou de manière électronique, sans interférence avec le maintien à distance de la source par le moyen du capteur. Enfin, dans certaines variantes de l'invention, la gravure de la résine s'effectue à l'endroit où a lieu la mesure de la distance, entre la source de rayonnement et une surface sensiblement parallèle à la surface de la résine.

On rappellera maintenant le principe de fonctionnement d'un capteur de proximité optique en champ proche du type à fibre. Une fibre optique, couplée de manière appropriée à une source de rayonnement électromagnétique (tel que par exemple une diode électroluminescente à bande étroite), émet, à son extrémité, une onde électromagnétique vers une surface réfléchissante ; le mode de propagation de cette onde résulte de la propagation guidée du rayonnement dans la fibre. Après réflexion sur la surface, l'onde est captée en retour par la fibre, où elle se propage suivant un mode guidé jusqu'à un récepteur qui mesure son intensité. En supposant de manière très réaliste, et justifiée notamment par l'expérience, que l'onde captée en retour par la fibre provient d'une fibre optique virtuelle, symétrique de la première fibre par rapport au plan délimité par la surface réfléchissante, on a montré que l'intensité recueillie par le récepteur est proportionnelle au couplage entre le mode de propagation de l'onde réfléchie dans l'air (et "émise" par la fibre virtuelle) et le mode de propagation principal dans la fibre du capteur de proximité. On constate alors une décroissance très rapide de l'intensité de l'onde détectée en fonction de la distance existant entre l'extrémité de ladite fibre et la surface réfléchissante.

Ce phénomène est mis à profit, dans la demande de brevet française N^{o}89-11 297 déjà mentionnée, pour obtenir, par balayage, la topographie d'une surface à étudier, ou des informations spectroscopiques localisées sur cette surface. On a montré notamment que les résolutions verticale et latérale d'un tel dispositif de microscopie peuvent respectivement atteindre des valeurs proches de 10 nanomètres et de 50 nanomètres. Par ailleurs, la décroissance de l'intensité est encore sensible (et donc utilisable) pour une distance de plusieurs micromètres.

Conformément au procédé de la présente invention, tel que défini dans la revendication 1, on peut donc balayer, et graver la surface d'une résine sensible à un rayonnement, en maintenant la source de ce rayonnement à une distance allant de quelques dizaines de nanomètres à plusieurs micromètres ; les risques de collision entre la source et la résine sont ainsi notablement diminués. En outre, la résolution latérale du balayage est très suffisante, puisqu'on veut réaliser, sur une plaquette de silicium, des motifs dont la taille n'est pas inférieure à 100 nanomètres.

Par ailleurs, aucune métallisation de la surface n'est nécessaire au fonctionnement du capteur de proximité. La résine déposée sur la plaquette de silicium peut être ainsi de toute nature : sensible aux rayonnements ultraviolets ("photoresist"), ou sensible aux rayonnements non optiques ("electroresist"). En outre, son épaisseur ne jouant aucun rôle vis à vis du contrôle de proximité, il devient très avantageux de déposer des couches de résine très minces, ce qui améliore la résolution et diminue les temps d'exposition.

Suivant une première variante du procédé conforme à l'invention, on effectue la microlithographie du substrat, tel qu'une plaquette de silicium, par gravure photomécanique d'une résine photosensible préalablement déposée sur ce substrat, la longueur d'ondes de la lumière utilisée à cet effet étant sensiblement différente de la longueur d'ondes de l'onde électromagnétique servant à maintenir la source de ladite lumière à proximité de la surface à exposer par le moyen du capteur de proximité à fibre optique.

On peut par exemple, avec des résines photosensibles couramment utilisées, graver des motifs submicrométriques en utilisant une lumière ultraviolette (longueur d'ondes inférieure à 400 nanomètres). Ces résines sont par ailleurs transparentes aux rayonnements proches de l'infrarouge ou du rouge, et notamment à l'onde émise par un laser Hélium-Néon dont la longueur d'ondes vaut 6328 angstroems. On peut ainsi utiliser une lumière rouge pour le fonctionnement du capteur de proximité à fibre optique, et graver la résine photosensible de manière conventionnelle avec une lumière ultraviolette. Avantageusement, la lumière rouge traversant la couche de résine, le contrôle de la distance entre l'extrémité de la fibre du capteur et la surface de la résine est indirect ; la surface réfléchissante servant de référence au maintien de la distance est ainsi constituée par l'interface entre le substrat et la résine qui y est déposée. On s'affranchit, de cette manière :
- des irrégularités du dépôt de résine sur le substrat, d'une part,
- de la modification de la nature chimique de la résine lorsqu'elle est exposée, voire de ses modifications dimensionnelles,d'autre part.

On notera que la lumière servant à la mesure et la lumière servant à la gravure peuvent très avantageusement se propager dans la même fibre optique et être émise vers le substrat dans les mêmes conditions ; cette fibre optique est, bien entendu, celle qui est utilisée par le capteur de proximité. La gravure a donc lieu exactement à un endroit où on contrôle la distance entre la source (constituée dans ce cas par l'extrémité de la fibre optique) et le substrat.

Suivant une seconde variante du procédé conforme à l'invention, on effectue la microlithographie du substrat, tel qu'une plaquette de silicium, par gravure électromécanique d'une résine sensible aux électrons préalablement déposée sur ce substrat. Les électrons sont émis, à cet effet, par une pointe conductrice, soumise à l'action d'un champ électrique appliqué entre le substrat et ladite pointe. Par ailleurs, la pointe est rendue solidaire du capteur de proximité à fibre optique par un moyen approprié.

Cette variante du procédé selon l'invention nécessite la réalisation d'une source de rayonnement plus complexe que la source de rayonnement lumineux utilisée dans la première variante. Par exemple, ainsi qu'on le verra par la suite, on peut métalliser une partie de la fibre optique du capteur de proximité, et utiliser une aspérité en saillie de cette métallisation comme source d'électrons (on utilisera dans ce cas une émission d'électrons dite "émission de champ", en soumettant l'aspérité à un champ électrique supérieur à 10⁹ V/cm).

Dans les deux variantes susmentionnées, le balayage de la surface du substrat est contrôlé de manière très précise par des moyens conventionnels de déplacement latéral. La gravure s'effectue point par point, segment de droite par segment de droite, et les informations nécessaires au déplacement peuvent provenir directement d'un fichier informatique décrivant les motifs à réaliser par le moyen conventionnel d'un langage de description intermédiaire - on notera que cette technique est comparable à celle utilisée pour la photocomposition de masques -.

D'autres caractéristiques et avantages du procédé objet de la présente invention ressortiront mieux de la description qui va suivre de plusieurs dispositifs de microlithographie, donnés à titre d'exemples non limitatifs, mettant en oeuvre ce procédé en référence aux dessins annexés sur lesquels :
- la figure 1 est une vue schématique d'un dispositif de microlithographie conforme à une première variante de l'invention,
- la figure 2 est une vue schématique d'un dispositif de microlithographie conforme à une seconde variante de l'invention,
- la figure 3 est une vue schématique de l'extrémité d'un capteur de proximité utilisé dans le dispositif de microlithographie représenté sur la figure 2.

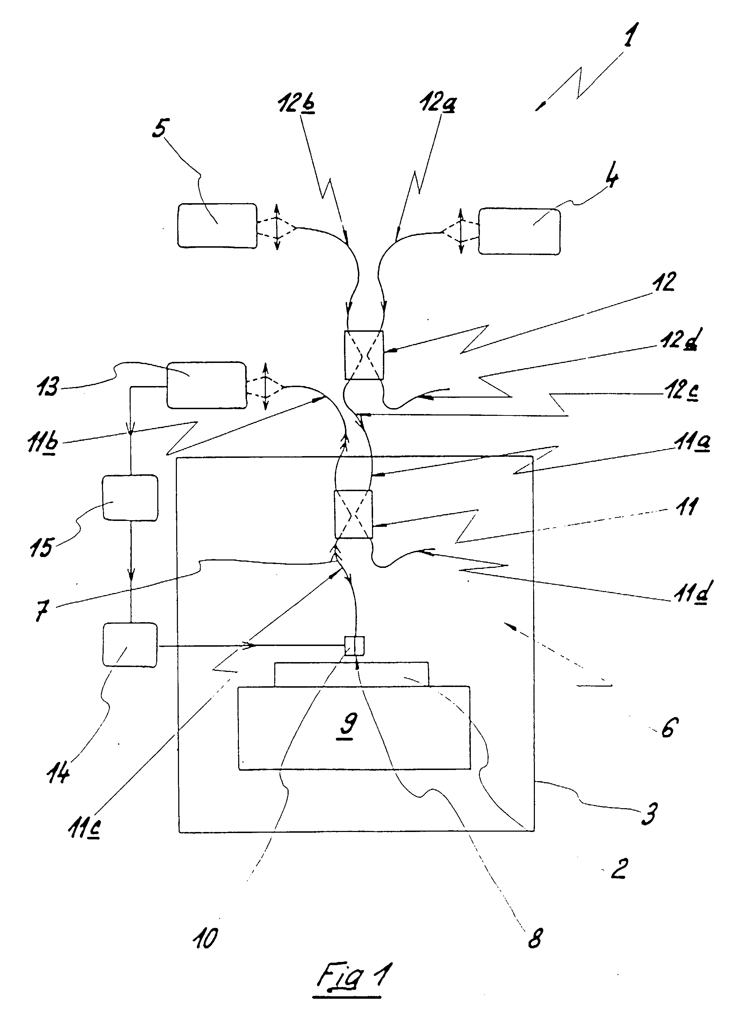

Conformément à la figure 1, une première variante d'un dispositif de microlithographie 1, pour la réalisation de structures submicrométriques à la surface d'un substrat 2 du type d'une plaquette de silicium, comporte :
- une enceinte étanche 3 dans laquelle est enfermé, sous atmosphère propre et contrôlée, un substrat 2 en vue de sa gravure,
- une source de lumière 4, par exemple ultraviolette, du type d'une lampe à haute-pression au xénon (ou au mercure, ou encore au xénon-mercure),
- une source de lumière 5, par exemple rouge, du type d'un laser à hélium-néon émettant une onde monochromatique à 6328 angstroems,
- un capteur de proximité 6 fonctionnant en champ proche, et comprenant notamment une fibre optique 7 servant, à son extrémité 8, de sonde optique,
- un support antivibratoire conventionnel 9 sur lequel repose le substrat 2. Ce support 9 peut éventuellement être associé à un moyen conventionnel de balayage, par exemple du type à vis micrométriques, qui permet de faire balayer latéralement la surface du substrat 2 par l'extrémité 8 de la fibre optique 7.
- un moyen conventionnel de positionnement vertical 10 de l'extrémité 8 de la fibre optique 7 par rapport à la surface du substrat 2. Ce moyen de positionnement vertical 10, par exemple du type comprenant un tube piezoélectrique à quadrants, peut également servir au déplacement latéral "fin" - c'est-à-dire submicrométrique - de l'extrémité 8 de la fibre optique 7.
- un premier coupleur optique 11 à fibres optiques, réalisé par exemple par un procédé de fusion/étirage. Ce premier coupleur optique 11 comprend deux voies de transmission 11a et 11b en entrée, et deux voies de transmission 11c et 11d en sortie. La fibre optique 7 constitue avantageusement la voie de transmission 11c en sortie du coupleur 11. La voie de transmission 11d en sortie est inutilisée.
- un deuxième coupleur optique 12 à fibres optiques, du même type que le coupleur optique 11. Ce second coupleur optique 12 comprend deux voies de transmission 12a et 12b en entrée, et deux voies de transmission 12c et 12d en sortie. La voie de transmission 12c en sortie est reliée, par un moyen approprié, à la voie de transmission 11a en entrée du coupleur optique 11. La voie de transmission 12a en entrée du coupleur optique 12 est couplée à la source de lumière 4, par exemple ultraviolette, par un moyen conventionnel approprié, pouvant comporté éventuellement un jeu de filtres. L'autre voie de transmission 12b en entrée est couplée, quant à elle, à la source de lumière 5, par exemple rouge, par un autre moyen conventionnel approprié. La voie de transmission 12d est inutilisée.
- un détecteur de photons 13, tel que par exemple un photomultiplicateur, sensible uniquement à la lumière émise par la source 5. Ce détecteur 13 est couplé à la voie de transmission 11b en entrée du coupleur optique 11.
- un dispositif à contre-réaction 14, reliant le moyen de positionnement vertical 10 de l'extrémité 8 de la fibre optique 7 à un ordinateur 15 contrôlant notamment, en fonction de l'intensité recue par le détecteur de photons 13, la distance entre l'extrémité 8 de la fibre optique 7 et la surface du substrat 2. Cet ordinateur 15 permet également de contrôler les déplacements latéraux réciproques du substrat 2 et de l'extrémité 8 de la fibre 7.

De manière conventionnelle, le substrat 2, tel qu'une plaquette de silicium, a été tout d'abord oxydé en surface ; on a obtenu à sa surface une couche de silice dans laquelle on désire dégager des zones susceptibles d'être postérieurement soumises à un bombardement d'ions, en vue de la modification des caractéristiques électriques locales du silicium.

Pour réaliser cette gravure, il convient de créer à la surface du substrat 2 des zones de réserve qui seront ensuite gravées par une gravure en phase liquide (par exemple à l'aide d'un acide) ou par une gravure sèche (par exemple par plasma). Pour créer ces zones de réserve, on dépose une résine photosensible sur la couche de silice du substrat 2, et on l'expose suivant les motifs à réaliser.

On donnera par la suite un exemple précis d'une telle microlithographie par le moyen du dispositif 1 de l'invention.

Après dépôt de la résine photosensible sur le substrat 2, on place celui-ci dans l'enceinte étanche 3, où règne une atmosphère propre et contrôlée. Le fonctionnement du dispositif de microlithographie 1 est alors le suivant.

Un fichier informatique mémorisé dans l'ordinateur 15 décrit de manière exacte la totalité des motifs à graver sur le substrat 2. Ces motifs se composent essentiellement de segments de droites, de largeur donnée, et dont le positionnement sur le substrat 2 doit être parfait. La procédure d'exposition d'un segment de droite peut être ainsi détaillée :
a) l'ordinateur 15 commande, par l'intermédiaire du moyen de balayage latéral conventionnel qui est intégré au support antivibratoire 9, le positionnement du substrat 2 par rapport à l'extrémité 8 de la fibre optique 7 ; ce premier positionnement est effectué avec une précision micrométrique. Puis, l'ordinateur 15 commande le déclenchement de la source de lumière 5.
b) la lumière issue de cette source 5 se propage dans la voie de transmission 12b en entrée du coupleur optique 12 ; puis un pourcentage donné de l'intensité de cette lumière (par exemple 50%) se propage dans la voie de transmission 12c, et la totalité de la lumière issue du coupleur 12 se propage alors dans la voie de transmission 11a en entrée du coupleur optique 11. Un pourcentage donné de l'intensité de la lumière se propageant dans la voie de transmission 11a (par exemple 50%) se propage alors dans la voie de transmission 11c en sortie du coupleur 11, que constitue avantageusement la fibre optique 7.
c) une partie de la lumière issue de la source 5 est ainsi émise, par l'extrémité 8 de la fibre 7, vers la surface du substrat 2, où elle se réfléchit avantageusement à l'interface entre le substrat 2 et la résine photosensible (celle-ci est transparente pour la longueur d'onde qui est issue de la source 5).
d) la lumière rétrodiffusée est recueillie par l'extrémité 8, et se propage alors dans la fibre optique 7 dans le sens inverse du sens de l'émission ; un pourcentage donné de cette lumière rétrodiffusée (soit 50%) passe de cette façon dans la voie de transmission 11b en entrée du coupleur 11, où elle est recueillie, après un filtrage éventuel, par le détecteur de photons 13. L'intensité mesurée par ce détecteur 13 est envoyée, sous une forme par exemple numérique, vers l'ordinateur 15 où est enregistré une valeur de consigne pour cette intensité ; cette valeur de consigne représente, conformément au principe de la mesure de proximité précédemment décrite, la distance que l'on souhaite maintenir entre l'extrémité 8 de la fibre optique 7 et la surface du substrat 2 - on notera, ainsi qu'il est décrit dans la demande de brevet française N°89-xxxxx déjà mentionnée, que l'extrémité 8 de la fibre optique 7 doit présenter préférentiellement une surface de sortie plane, perpendiculaire au sens de propagation de la lumière dans la fibre 7, et être maintenue sensiblement parallèle à la surface du substrat 2 en regard -.
e) en fonction de la comparaison entre l'intensité recueillie par le détecteur et ladite valeur de consigne, l'ordinateur 15 envoie un signal au dispositif de contre-réaction 14, de manière à agir sur le moyen de positionnement vertical 10 de l'extrémité 8 de la fibre optique 7. Le capteur de proximité 6 fonctionne, en conséquence, au moyen d'une classique contre-réaction.
f) l'extrémité 8 de la fibre optique 7 étant positionnée verticalement à la distance souhaitée du substrat 2, l'ordinateur 15 agit alors, par l'intermédiaire du dispositif 14, sur les moyens de positionnement latéral "fin" qui sont intégrés au moyen de positionnement vertical 10, pour positionner latéralement ladite extrémité de manière fine ; par exemple, si le moyen de positionnement vertical 10 est un tube piezoélectrique à quadrants, l'ordinateur 15 peut commander au dispositif 14 de soumettre les quadrants à des tensions appropriées, pour déplacer latéralement l'extrémité 8 de la fibre 7 avec une précision nanométrique - on rappelle qu'un déplacement vertical est obtenu, avec un tube piezoélectrique du type mentionné, en soumettant l'électrode interne au tube à une différence de potentiel par rapport à l'ensemble des quadrants -.
g) ce positionnement préalable étant effectué, l'ordinateur 15 commande simultanément le déclenchement de la source de lumière 4, par exemple ultraviolette, et le déplacement réciproque de l'extrémité 8 de la fibre optique 7 et du substrat 2 (c'est-à-dire le déclenchement du moyen de déplacement latéral micrométrique intégré au support antivibratoire 9, et le déclenchement du moyen de positionnement "fin" intégré au moyen de déplacement vertical 10 de l'extrémité 8 de la fibre optique 7).
h) le fonctionnement de cette source 4 peut être continu ou intermittent, suivant la continuité des segments de droites à graver sur la résine photosensible. En l'espèce, la lumière issue de cette source 4 se propage, après filtrage, dans la voie de transmission 12a en entrée du coupleur optique 12, puis un pourcentage donné (par exemple 50%) de cette lumière passe dans la voie de transmission 12c en sortie dudit coupleur 12, d'où elle est ré-émise vers la voie de transmission 11a en entrée du coupleur optique 11. Un certain pourcentage de cette lumière se propage enfin dans la voie de transmission 11c dudit coupleur 11, que constitue avantageusement la fibre optique 7 du capteur de proximité 6.
i) une partie de la lumière, par exemple ultraviolette, issue de la source 4, est ainsi émise vers le substrat 2, à proximité de celui-ci. La résine photosensible est alors gravée suivant le motif décrit par le déplacement réciproque de l'extrémité 8 de la fibre optique 7 et du substrat 2. Durant tout le temps que dure la gravure, le dispositif à contre-réaction 14 assure, grâce à la mesure fournie par le détecteur de photons 13, le maintien de l'extrémité 8 de la fibre 7 à proximité de la surface du substrat 2 ; cette mesure continue est possible en raison des faibles variations attendues de la distance mesurée, puisque la surface de la silice recouvrant le substrat 2, tel qu'une plaquette de silicium, présente une rugosité peu importante.

Il convient de bien remarquer que le fonctionnement précédemment décrit du dispositif de microlithographie 1 conforme à l'invention est particulièrement avantageux. On a ainsi constaté qu'on peut graver une résine photosensible préalablement déposée sur un substrat 2 sans métalliser ledit substrat 2. Le maintien de la source émettant la lumière de gravure vers le substrat 2 s'effectue de manière purement optique, et le fonctionnement du capteur de proximité 6 est totalement disjoint de celui de la gravure ; aucune interférence entre les deux fonctionnements n'est alors à redouter. En outre, du fait qu'on grave exactement à l'endroit où la mesure de proximité est réalisée, il ne peut y avoir de décalage entre mesure et gravure.

On a pu, de cette façon, préparer un échantillon d'une plaquette de silicium. Celle-ci, après oxydation superficielle pour réalisation d'une couche mince de silice protectrice, a été nettoyée conventionnellement par des solvants appropriés. Puis on a effectué un recuit de déshydratation à 200°C de la plaquette de silicium. On a ensuite utiliser le processus et les produits recommandés par la Société de droit américain Shipley Company Inc., qui fait autorité dans le domaine de l'invention. Après recuit (étuvage), on a dispensé sur la surface de la plaquette de silicium un promoteur d'adhésion appelé commercialement "Microposit Primer" ; ce produit améliore notablement l'adhésion de la résine sur la surface de la silice. Puis on a dispensé une résine photosensible positive dénommée commercialement "Microposit 3000 Resist" ; cette résine peut être exposée par un rayonnement ultraviolet d'environ 3000 angstroems (300 nanomètres). Ce rayonnement se propage sans difficulté dans les fibres optiques en silice utilisées pour la réalisation de coupleurs optiques du type des coupleurs 11 et 12 (la longueur d'ondes en dessous de laquelle un rayonnement ne se propage plus dans une fibre en silice, ou en quartz, est de 180 nanomètres). On notera que la dispense de la résine photosensible sur la plaquette de silicium a été effectuée en phase liquide sur une tournette, telle que celle comprise dans le système connu commercialement sous le nom de "Système 6000" fabriqué par la société américaine Eaton. La vitesse de rotation de la tournette était de 9000 tours/minute et on a ainsi pu obtenir, en 20 secondes, une couche de résine photosensible de faible épaisseur, soit 0,6 micromètres. Cette épaisseur peut être notablement diminuée en modifiant la viscosité de la résine au moyen d'un solvant dénommé commercialement "Microposit Thinner type 30". On notera que cette résine est transparente pour un rayonnement issu d'un laser hélium-néon dont la longueur d'ondes vaut 6328 angstroems.

On a ensuite procédé à un faible recuit de la résine, de manière à évaporer les solvants, à accroître l'adhérence, et à durcir légèrement la résine en vue de son transport vers l'enceinte étanche 3 du dispositif de microlithographie 1 conforme à l'invention, ce transport s'effectuant bien entendu sous atmosphère contrôlée et en salle blanche (par exemple de classe 10), au moyen d'un carrousel adapté à cet usage.

Conformément au processus, précédemment décrit, et objet de la présente invention, on a alors procédé à l'exposition de la résine photosensible. Le temps d'exposition dépend bien entendu de la puissance optique des lampes à haute pression utilisées comme source de lumière 4.

La plaquette de silicium a ensuite été transférée dans une enceinte où la résine photosensible a été développée au moyen du produit dénommé commercialement "Microposit 300 Developer", puis rincée plusieurs fois à l'eau désionisée, et enfin séchée sous atmosphère d'azote. Un recuit de la résine à 90°C pendant 20 minutes est ensuite réalisé.

Enfin, les zones de silice délimitées par les réserves de résine sont gravées en utilisant une gravure sèche par plasma, dont les performances sont bien connues.

L'observation ultérieure de la plaquette de silicium au moyen, d'une part, d'un microscope électronique, et, d'autre part, du microscope optique en champ proche du type à fibre, objet de la demande de brevet française N^{o}89-11 297 déjà mentionnée, a montré que des motifs d'une largeur de 100 nanomètres ont pu être réalisés. Les autres conditions expérimentales de cette réalisation sont les suivantes : la fibre optique 7, servant à la fois au capteur de proximité 6 et comme source du rayonnement de gravure, présente, à son extrémité 8, un coeur de 500 nanomètres de diamètre et une gaine de 1 micromètres de diamètre - ces caractéristiques en bout de fibre 7 ont été obtenues par attaque chimique et fusion/étirage de l'extrémité de la voie de transmission 11c en sortie d'un coupleur optique 11, fabriqué par la Société de droit américain Gould Inc, présentant un coeur de 4 micromètres de diamètre, et une gaine de 125 micrométres de diamètre -.

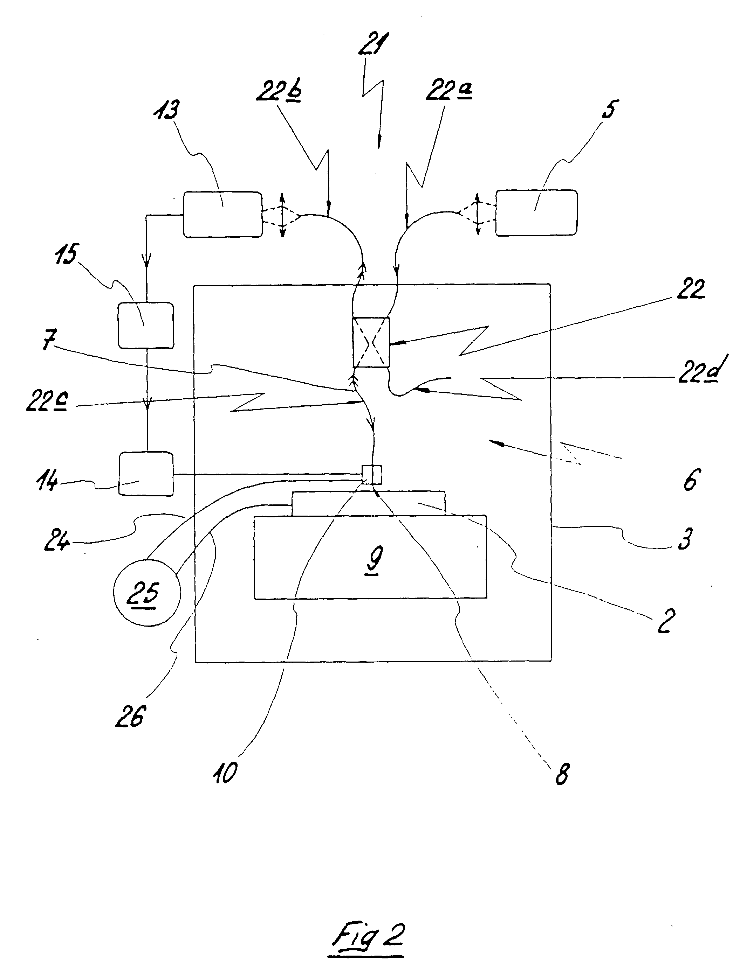

On décrira maintenant, en référence à la figure 2, un dispositif de microlithographie 21 conforme à une seconde variante de mise en oeuvre du procédé objet de la présente invention.

Sur cette figure, les numéros qui sont identiques aux numéros apparaissant sur la figure 1 désignent des éléments identiques, qui sont donc communs aux deux variantes données en exemple de l'invention.

Le dispositif de microlithographie 21 pour la réalisation de structures submicrométriques sur un substrat 2 du type d'une plaquette de silicium, comporte de cette façon :
- une enceinte étanche 3,
- une source de lumière 5, par exemple rouge, du type d'un laser hélium-néon,
- un capteur de proximité 6 fonctionnant en champ proche, et comprenant notamment une fibre optique 7 servant, à son extrémité 8, de sonde optique,
- un support antivibratoire conventionnel 9 sur lequel repose le substrat 2.
- un moyen conventionnel de positionnement vertical 10 de l'extrémité 8 de la fibre optique 7 par rapport à la surface du substrat 2. Ce moyen de positionnement 10 peut également servir au positionnement latéral "fin" de ladite extrémité 8.
- un coupleur optique 22 à fibres optiques, d'un type conforme aux coupleurs optiques déjà mentionnés. Ce coupleur optique 22 comprend deux voies de transmission 22a et 22b en entrée, et deux voies de transmission 22c et 22d en sortie. La fibre optique 7 constitue avantageusement la voie de transmission 22c en sortie du coupleur 22. La voie de transmission 22d en sortie est inutilisée. La voie de transmission 22a en entrée est couplée à la source de lumière 4, par exemple rouge, par un moyen conventionnel approprié.
- un détecteur de photons 13, tel que par exemple un photomultiplicateur, sensible à la lumière émise par la source 5. Ce détecteur 13 est couplé à la voie de transmission 22b en entrée du coupleur optique 22.
- un dispositif à contre-réaction 14, reliant le moyen de positionnement vertical 10 à un ordinateur 15 contrôlant notamment, en fonction de l'intensité reçue par le détecteur de photons 13, la distance entre l'extrémité 8 de la fibre optique 7 et la surface du substrat 2. L'ordinateur 15 permet également de contrôler les déplacements latéraux réciproques du substrat 2 et de l'extrémité 8 de la fibre 7.

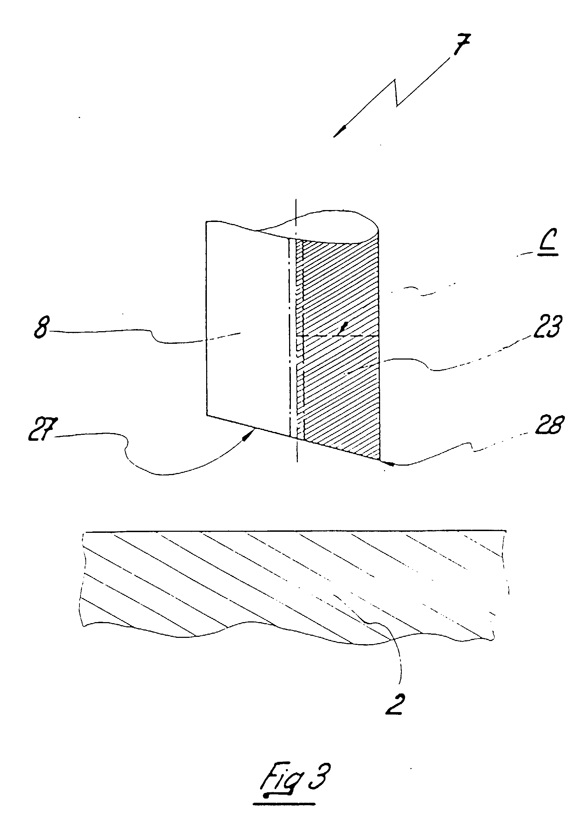

Conformément à la figure 3, et selon une caractéristique complémentaire du dispositif de microlithographie 21, au moins l'extrémité 8 de la fibre optique 7, du capteur de proximité 6 fonctionnant en champ proche, est métallisée. La couche de métal 23 déposée sur la fibre optique 7 peut s'étendre partiellement autour de son extrémité 8, suivant par exemple un demi-cylindre dont la génératrice est un arc de cercle C tracé fictivement autour de ladite fibre 7. En outre, une telle couche de métal 23 présente une épaisseur la rendant transparente à la lumière se propageant dans la fibre 7 ; elle ne trouble notamment pas la récupération, par l'extrémité 8 de la fibre 7, de la lumière émise vers le substrat 2 et rétrodiffusée par celui.

La couche de métal 23 est brasée, ou préférentiellement collée avec une colle conductrice appropriée, sur l'extrémité d'un fil conducteur fin non représenté sur les figures. Ce fil aboutit à un connecteur également non représenté, d'où part un fil 24 de plus gros diamètre, traversant l'enceinte étanche 3 de manière adéquate, de manière à être électriquement connecté à une alimentation électrique 25 à basse tension. La surface du substrat 2 est également reliée, par un connecteur électrique 26, à cette alimentation 25. Une différence de potentiel peu élevée, de l'ordre de 25 volts, peut ainsi être appliquée entre la couche de métal 23 et la surface du substrat 2, distante de l'extrémité 8 de la fibre optique 7 métallisée de quelques dizaines de nanomètres. Le champ électrique très important qui en résulte, renforcé par l'effet bien connu dit "de pointe", provoque l'émission d'un courant d'électrons localisé à l'extrémité 8 de ladite fibre 7.

Il convient de noter qu'on a choisi de représenter sur la figure 3 une fibre optique 7 présentant une extrémité 8 non étirée par un procédé de fusion/étirage, ni amincie en pointe par une attaque chimique préalable, ce qui sera discuté plus loin. Conformément à la figure 3, la face de sortie 24 de la fibre optique 7 est donc plane. L'orientation de cette face 27, par rapport à la direction longitudinale de propagation de la lumière dans la fibre 7, n'est pas orthogonale, mais présente un angle de quelques degrés (3 à 4°) ; cette configuration particulière propre à une variante particulière non limitative de l'invention procure le moyen de délimiter une partie de la couche de métal 23 qui forme sensiblement une pointe métallique 28. L'extrémité de cette pointe métallique 28 est donc plus proche de la surface du substrat 2 que le milieu de la face de sortie 27 de la fibre 7 ; ce n'est pas un inconvénient, car il suffit d'en tenir compte dans les paramètres de la contre-réaction grâce à laquelle fonctionne le capteur de proximité 6. C'est donc la pointe métallique 28 qui émet, dans ce cas, les électrons vers la surface du substrat 2.

Par ailleurs, le fait que la face de sortie 27 de la fibre optique 7 ne soit pas parallèle à la surface du substrat 2 modifie peu, vu l'angle d'inclinaison de cette face 27, les caractéristiques de la mesure ; on peut également en tenir compte assez aisément - cette configuration a en effet pour conséquence principale de diminuer le niveau de l'intensité recueillie par le détecteur de photons 13, mais la puissance de la source de lumière 5, telle qu'un laser hélium-néon, est très suffisante, ou peut être notablement augmentée -.

Suivant une autre variante de réalisation non représentée sur les figures d'une métallisation de l'extrémité 8 de la fibre optique 7, une couche de métal recouvre la totalité de la surface de ladite extrémité 8, qui a été préalablement étirée par un procédé de fusion/étirage connu en soi, puis débarrassée d'une partie de sa gaine par attaque chimique (au moyen d'un acide du type HF). Seule la face de sortie de la fibre 7 peut éventuellement être débarrassée ultérieurement du dépôt de métal qui la recouvre, mais il ne s'agit pas d'une nécessité. L'avantage de cette dernière technique de réalisation d'une pointe à l'extrémité 8 de la fibre optique 7 est de localiser au même endroit exactement l'émetteur de la lumière utilisée par le capteur de proximité 6, et une pointe métallique susceptible d'émettre des électrons, sous l'action du champ électrique résultant de la différence de potentiel fournie par l'alimentation électrique 25.

La procédure d'utilisation du dispositif de microlithographie 21 est sensiblement identique à la procédure de fonctionnement du dispositif de microlithographie 1 conforme à la première variante décrite. Seule change la nature de la résine et la nature de son exposition.

De cette façon, on a remplacé la résine photosensible positive par une résine se polymérisant sous l'action d'un faisceau d'électrons, et par exemple par une résine négative du type connue sous le nom de PMMA (il s'agit d'un photopolymère très utilisé dans le domaine de l'invention). Cette résine est dissoute dans du chlorobenzène, puis déposée en phase liquide sur une plaquette de silicium préalablement étuvée et enduite d'un agent promoteur d'adhésion ; la dispense de résine s'effectue sur une tournette tournant à 8000 tours/minute. Après recuit de la résine pendant 8 heures, à une température de 175°C, on obtient une couche de résine PMMA de 20 angstroems d'épaisseur.

On place la plaquette de silicium dans l'enceinte étanche 3 et on procède au positionnement de l'extrémité 8 de la fibre optique 7 métallisée à proximité de la surface du substrat 2. Ce positionnement préalable étant effectué, l'ordinateur 15 commande simultanément le déclenchement de l'alimentation électrique 25 et le déplacement réciproque de l'extrémité 8 de la fibre optique 7 et du substrat 2 (c'est-à-dire déclenche le moyen de positionnement intégré au support antivibratoire 9, et le moyen de positionnement latéral "fin" intégré au moyen de positionnement vertical 10).

Des électrons de 25 volts peuvent ainsi impressionner la résine PMMA suivant des motifs dont la description est fournie informatiquement par l'ordinateur 15. Durant toute l'exposition, le capteur de proximité 6 maintient une distance de quelques dizaines de nanomètres entre la surface du substrat 2 et l'extrémité 8 de la fibre optique 7 métallisée ; on rappelle que la surface servant de référence à la mesure effectuée par ledit capteur 6, à la longueur d'ondes, par exemple, d'une lumière émise par un laser hélium-néon, est constituée par l'interface entre la résine et la surface de la couche de silice qui recouvre uniformément la plaquette de silicium. Le développement de la résine PMMA, exposée par des électrons accélérés sous une différence de potentiel de 25 volts, peut s'effectuer avec de l'acétone (le développement enlève, pour les résines négatives, les parties exposées). On notera que pour des électrons de moindre énergie, les parties exposées peuvent être solubilisées dans un composé de méthanol.

Un recuit classique permet de durcir la résine, avant que les parties de la plaquette de silicium, qui ont été révélées et qui sont délimitées par les réserves "photographiques", ne soient soumises à une irradiation d'ions visant à modifier la structure sous-jacente du silicium.

Les motifs réalisés dans ce cas ont pu être observés par microscopie électronique ; leur taille peut atteindre 100 nanomètres.

Dans les deux variantes de réalisation d'un dispositif de microlithographie mettant en oeuvre le procédé objet de la présente invention, il convient enfin de préciser que la vitesse linéaire "d'écriture" sur la résine a atteint 1 micromètre/seconde.

En outre, et suivant une troisième de réalisation d'un dispositif de microlithographie non représenté sur les figures, mais conforme pour l'essentiel au dispositif de microlithographie 1 représenté sur la figure 1, la fibre optique 7 est une fibre fluorescente, la longueur d'ondes de la lumière fluorée pouvant atteindre des valeurs notablement inférieures à la limite de propagation d'une onde optique dans une fibre en silice ou en quartz (soit 180 nanomètres). En particulier, on sait réaliser des fibres fluorescentes réémettant dans le domaine des rayons X ; un dispositif de microlithographie conforme à l'invention, et utilisant une fibre de ce type, peut, par sa simplicité, concurrencer de manière très avantageuse les procédés de microlithographie en rayons X au travers de masques très fins, difficiles à réaliser et à positionner sur une plaquette de silicium.

Il est bien entendu évident que le procédé et les dispositifs de microlithographie objets de la présente invention ne sont en aucune manière limités par la description qui en a été donnée, ou par les dessins annexés, donnés uniquement à titre indicatif non limitatif.

Le domaine de l'invention est celui de la microlithographie d'un substrat du type d'une plaquette de silicium, en vue de réaliser à sa surface des structures submicrométriques, voire nanométriques.

## Revendications

1. Procédé de microlithographie directe à balayage, d'un substrat, du type d'une plaquette de silicium, par un faisceau optique et/ou électronique de traitement émis par un émetteur, en vue de réaliser une gravure photomécanique ou électromécanique de structures submicrométriques à la surface dudit substrat, dans lequel on utilise un capteur de proximité (6) comportant une source de lumière (5) reliée à une fibre optique (7) dont l'extrémité constitue une sonde (8), on maintient cette sonde dans le champ proche du substrat (2) de manière à diriger vers celui-ci de la lumière émise par la source de lumière (5), une partie de cette lumière étant réfléchie par la surface du substrat (2) et recueillie par l'extrémité de la sonde (8) et guidée en retour dans la fibre optique (7) vers des moyens de détection (13) et de traitement de données (15) commandant un dispositif à contre-réaction, caractérisé en ce qu'on réunit l'émetteur du faisceau de traitement à la sonde (8) de sorte que la sonde présente en même temps une source pour le faisceau de traitement et la gravure s'effectue à l'endroit où a lieu la mesure effectuée par le capteur de proximité afin de maintenir une distance constante entre l'émetteur et la surface du support (9) se trouvant immédiatement en-dessous de l'extrémité de la sonde (8).

2. Procédé de microlithographie selon la revendication 1, dans lequel on effectue une gravure photomécanique à l'aide d'un faisceau de photons qu'on applique à travers la sonde (8) du capteur de proximité (6).

3. Procédé de microlithographie selon la revendication 1, dans lequel on effectue une gravure électromécanique à l'aide d'un faisceau d'électrons émis par une couche métallique fixée à l'extrémité de la sonde (8) du capteur de proximité (6).

4. Dispositif pour la mise en oeuvre du procédé suivant l'une quelconque des revendications 1 à 3 pour la microlithographie d'un substrat du type d'une plaquette de silicium sur lequel a été préalablement déposée une résine en vue de réaliser à sa surface des structures submicrométriques, comportant un support (9) destiné à recevoir le substrat (2) lors de la microlithographie, un émetteur (8; 23) d'un faisceau de traitement auquel est sensible ladite résine, des moyens de déplacement horizontal relatif entre le faisceau de traitement et le support (9) pour tracer les structures submicrométriques dans la résine du substrat (2), et un capteur de proximité (6) comportant une source de lumière (5) reliée à une fibre optique (7) dont l'extrémité constitue une sonde (8), cette sonde étant maintenue dans le champ proche du substrat (2) de manière à diriger vers celui-ci de la lumière émise par la source de lumière (5), une partie de cette lumière étant réfléchie par la surface du substrat (2) et recueillie par l'extrémité de la sonde (8) et guidée en retour dans la fibre optique (7) vers un photodétecteur (13) lui-même relié a des moyens de traitement de données (15) commandant un dispositif à contre-réaction (14) caractérisé en ce que l'émetteur du faisceau de traitement et la sonde (8) sont réunis de sorte que la sonde presente en même temps une source pour le faisceau de traitement et la gravure s'effectue à l'endroit où a lieu la mesure effectuée par le capteur de proximité, et en ce que le dispositif de contre-réaction (14) agit sur des moyens de positionnement vertical (10) du substrat (2) de manière à maintenir une distance constante entre l'émetteur et la surface du support (9) se trouvant immédiatement en-dessous de l'extrémité de la sonde.

5. Dispositif de microlithographie suivant la revendication 4, caractérisé en ce que le faisceau de traitement est un faisceau de photons pour la gravure photomécanique issu d'une deuxième source de lumière (4) reliée à cet effet à la sonde (8) constituant l'émetteur du faisceau.

6. Dispositif de microlithographie suivant la revendication 4 ou 5, caractérisé en ce que la fibre optique (7) reçoit la lumière en provenance de la source de lumière (5) du capteur de proximité (6) par l'intermédiaire d'un premier coupleur optique (11, 22) dont une voie de transmission (11a, 22a) en entrée est reliée à la source de lumière (5) et une voie de transmission (11c, 22c) en sortie est reliée à la fibre optique (7), une troisième voie de transmission (11b, 22b) étant reliée au photodétecteur (13).

7. Dispositif de microlithographie suivant la revendication 6, caractérisé en ce que le coupleur (11) est un premier coupleur dont la voie d'entrée (11a) est reliée à une voie de sortie (12c) d'un deuxième coupleur ayant une première voie d'entrée reliée à la source de lumière (5) du capteur de proximité (6) et une deuxième voie d'entrée (12a) reliée à la deuxième source de lumière (4) émettant le faisceau de traitement.

8. Dispositif de microlithographie suivant la revendication 4 ou 6, caractérisé en ce que le faisceau de traitement est un faisceau d'électrons émis par un émetteur constitué d'une couche métallique (23) appliquée sur au moins une partie de la périphérie de la sonde (8) et reliée à un fil conducteur la connectant électriquement à une alimentation électrique (25), et en ce que le faisceau d'électrons de traitement est parallèle au faisceau de la sonde (8) du capteur de proximité.

9. Dispositif de microlithographie suivant la revendication 8, caractérisé en ce que la couche métallique recouvre toute la périphérie de la sonde (8) dont l'extrémité est conformée en une pointe qui est localisée au même endroit que l'émetteur de la lumière utilisée par le capteur de proximité (6).

10. Dispositif de microlithographie suivant la revendication 9, caractérisé en ce que la face de sortie de la fibre (7) de la sonde (8) est dépourvue de couche métallique.

11. Dispositif de microlithographie suivant la revendication 8, caractérisé en ce que la couche métallique est conformée en demi-cylindre (23) dont la génératrice est un arc de cercle (C) tracé autour de la fibre (7) de la sonde (8).

12. Dispositif de microlithographie en suivant la revendication 11, caractérisé en ce que la face d'extrémité (27) de la sonde (8) forme un angle de quelques degrés par rapport à la direction longitudinale de propagation du faisceau dans la fibre (7) de sorte que le demi-cylindre (23) forme une pointe (28) dirigée vers la surface du substrat.

## Patentansprüche

1. Verfahren zur direkten Mikrolithographie mittels Rastern eines Substrats von der Art eines Siliziumwafers durch einen optischen und/oder elektronischen, von einer Emissionsstelle emittierten Strahl zur Behandlung, um eine photo- oder elektromechanische Gravur von Submikrometerstrukturen auf der Oberfläche dieses Substrats auszuführen, bei dem ein Abstandssensor (6) mit einer Lichtquelle (5) verwendet wird, die mit einer Lichtleitfaser (7) verbunden ist, deren Ende eine Sonde (8) ausbildet, welche im Nahfeld des Substrats (2) derart gehalten wird, daß von der Lichtquelle (5) ausgesandtes Licht auf das Substrat gerichtet wird, wobei ein Teil dieses Lichts von der Oberfläche des Substrats (2) reflektiert und von dem Ende der Sonde (8) gesammelt und auf dem Rückweg in die Lichtleitfaser (7) zu einer Detektionseinrichtung (13) und einer Datenverarbeitungseinrichtung (15) geführt wird, welche eine Gegenkopplungseinrichtung steuert, dadurch gekennzeichnet, daß die Emissionsstelle des Strahls zur Verarbeitung und die Sonde (8) vereinigt werden, so daß die Sonde gleichzeitig eine Quelle für den Strahl zur Behandlung aufweist und die Gravur an dem Ort der durch den Abstandssensor durchgeführten Messung erfolgt, damit ein konstanter Abstand zwischen der Emissionsstelle und der Oberfläche der Auflage (9), die sich unmittelbar unterhalb des Endes der Sonde (8) befindet, beibehalten wird.

2. Mikrolithographie-Verfahren nach Anspruch 1, bei dem eine photomechanische Gravur mit Hilfe eines Photonenstrahls durchgeführt wird, der über die Sonde (8) des Abstandssensors (6) angesetzt wird.

3. Mikrolithographie-Verfahren nach Anspruch 1, bei dem eine elektromechanische Gravur mit Hilfe eines Elektronenstrahls durchgeführt wird, der von einer am Ende der Sonde (8) des Abstandssensors (6) befestigten Metallschicht emittiert wird.

4. Vorrichtung zur Durchführung des Verfahrens nach einem der Ansprüche 1 bis 3 zur Mikrolithographie eines Substrats von der Art eines Siliziumwafers, auf dem zuvor ein Harz aufgebracht wurde, um auf seiner Oberfläche Submikrometerstrukturen auszubilden, wobei die Vorrichtung folgendes aufweist:
eine Auflage (9) zur Aufnahme des Substrats (2) bei der Mikrolithographie,
eine Emissionsstelle (8; 23) für einen Strahl zur Behandlung, auf den das Harz empfindlich ist,
Mittel zur relativen Horizontalverschiebung zwischen dem Strahl zur Behandlung und der Auflage (9), um die Submikrometerstrukturen in das Harz des Substrats (2) zu zeichnen, sowie
einen Abstandssensor (6) mit einer Lichtquelle (5), die mit einer Lichtleitfaser (7) verbunden ist, deren Ende eine Sonde (8) ausbildet, wobei diese Sonde im Nahfeld des Substrats (2) derart gehalten wird, daß von der Lichtquelle (5) ausgesandtes Licht auf das Substrat gerichtet wird, wobei ein Teil dieses Lichts von der Oberfläche des Substrats (2) reflektiert und von dem Ende der Sonde (8) gesammelt und auf dem Rückweg in die Lichtleitfaser (7) zu einem Photodetektor (13) geführt wird, der wiederum mit einer Datenverarbeitungseinrichtung (15) verbunden ist, die eine Gegenkopplungseinrichtung (14) steuert, dadurch gekennzeichnet, daß die Emissionsstelle für den Strahl zur Behandlung und die Sonde (8) vereinigt sind, so daß die Sonde gleichzeitig eine Quelle für den Strahl zur Behandlung aufweist und die Gravur an dem Ort der durch den Abstandssensor durchgeführten Messung erfolgt, sowie dadurch, daß die Gegenkopplungseinrichtung (14) auf vertikale Positioniermittel (10) des Substrats (2) derart wirkt, daß ein konstanter Abstand zwischen der Emissionsstelle und der Oberfläche der Auflage (9), die sich unmittelbar unterhalb des Endes der Sonde befindet, beibehalten wird.

5. Vorrichtung zur Mikrolithographie nach Anspruch 4, dadurch gekennzeichnet, daß der Strahl zur Behandlung ein Photonenstrahl zur photomechanischen Gravur ist, der aus einer zweiten Lichtquelle (4) stammt, die zu diesem Zweck mit der Sonde (8), die die Emissionsstelle für den Strahl ausbildet, verbunden ist.

6. Vorrichtung zur Mikrolithographie nach Anspruch 4 oder 5, dadurch gekennzeichnet, daß die Lichtleitfaser (7) das von der Lichtquelle (5) kommende Licht des Abstandssensors (6) mit Hilfe eines ersten optischen Kopplers (11, 22) aufnimmt, von dem ein Übertragungskanal (11a, 22a) im Eingang mit der Lichtquelle (5) verbunden ist und ein Übertragungskanal (11c, 22c) im Ausgang mit der Lichtleitfaser (7) verbunden ist, wobei ein dritter Übertragungskanal (11b, 22b) mit dem Photodetektor (13) verbunden ist.

7. Vorrichtung zur Mikrolithographie nach Anspruch 6, dadurch gekennzeichnet, daß der Koppler (11) ein erster Koppler ist, dessen Eingangskanal (11a) mit einem Ausgangskanal (12c) eines zweiten Kopplers verbunden ist, der einen ersten Eingangskanal aufweist, welcher mit der Lichtquelle (5) des Abstandssensors (6) verbunden ist, und einen zweiten Eingangskanal (12a), der mit der zweiten Lichtquelle (4) verbunden ist, die den Strahl zur Behandlung aussendet.

8. Vorrichtung zur Mikrolithographie nach Anspruch 4 oder 6, dadurch gekennzeichnet, daß der Strahl zur Behandlung ein Elektronenstrahl ist, der von einem Emitter emittiert wird, welcher aus einer Metallschicht (23) besteht, die auf zumindest einem Teil der Peripherie der Sonde (8) aufgebracht und mit einem Leitungsdraht verbunden ist, der sie elektrisch an eine elektrische Versorgung (25) anschließt, und dadurch, daß der Elektronenstrahl zur Behandlung parallel zum Strahl der Sonde (8) des Abstandssensors ist.

9. Vorrichtung zur Mikrolithographie nach Anspruch 8, dadurch gekennzeichnet, daß die Metallschicht die gesamte Peripherie der Sonde (8) bedeckt, deren Ende als eine Spitze ausgestaltet ist, die sich am gleichen Ort wie die Emissionsstelle des vom Abstandssensor (6) verwendeten Lichts befindet.

10. Vorrichtung zur Mikrolithographie nach Anspruch 9, dadurch gekennzeichnet, daß die Ausgangsfläche der Faser (7) der Sonde (8) frei von einer Metallschicht ist.

11. Vorrichtung zur Mikrolithographie nach Anspruch 8, dadurch gekennzeichnet, daß die Metallschicht als Halbzylinder (23) ausgestaltet ist, dessen Mantellinie ein um die Faser (7) der Sonde (8) herum geschlagener Kreisbogen (C) ist.

12. Vorrichtung zur Mikrolithographie nach Anspruch 11, dadurch gekennzeichnet, daß die Endfläche (27) der Sonde (8) einen Winkel von einigen Grad bezüglich der Längsausbreitungsrichtung des Strahls in der Faser (7) bildet, so daß der Halbzylinder (23) eine zur Oberfläche des Substrats gerichtete Spitze (28) bildet.

## Claims

1. Direct microlithography process involving scanning of a substrate, of the type of a silicon wafer, with an optical and/or electron treatment beam emitted by an emitter in order photomechanically or electromechanically to etch submicron structures on the surface of the said substrate, in which process a proximity sensor (6) is used which comprises a light source (5) connected to an optical fibre (7), the end of which constitutes a probe (8), this probe is maintained within the near field of the substrate (2) in such a manner as to direct light emitted by the light source (5) towards the substrate, a proportion of this light being reflected by the surface of the substrate (2) and picked up by the end of the probe (8) and guided back up the optical fibre (7) towards detection (13) and data processing (15) means which control a negative feedback device, characterised in that the treatment beam emitter is joined to the probe (8) in such a manner that the probe simultaneously has a source for the treatment beam and etching proceeds at the point at which measurement is made by the proximity detector in order to maintain a constant distance between the emitter and the surface of the support (9) which is located immediately beneath the end of the probe (8).

2. Microlithography process according to claim 1 in which photomechanical etching is performed by means of a photon beam which is applied through the probe (8) of the proximity sensor (6).

3. Microlithography process according to claim 1 in which electromechanical etching is performed by means of an electron beam emitted by a metallic layer attached to the end of the probe (8) of the proximity sensor (6).

4. Apparatus for the performance of the process according to any of claims 1 to 3 for microlithography of a substrate of the type of a silicon wafer onto which a resin has previously been applied in order to create submicron structures on the surface of the substrate comprising a support (9) intended to accommodate the substrate (2) during microlithography, an emitter (8; 23) of a treatment beam to which the said resin is sensitive, means for horizontally displacing the treatment beam relative to the support (9) to image submicron structures in the resin of the substrate (2), and a proximity sensor (6) which comprises a light source (5) connected to an optical fibre (7), the end of which constitutes a probe (8), this probe being maintained within the near field of the substrate (2) in such a manner as to direct light emitted by the light source (5) towards the substrate, a proportion of this light being reflected by the surface of the substrate (2) and picked up by the end of the probe (8) and guided back up the optical fibre (7) towards a photodetector (13), itself connected to data processing means (15) which control a negative feedback device (14), characterised in that the treatment beam emitter and the probe (8) are joined in such a manner that the probe simultaneously has a source for the treatment beam and etching proceeds at the point at which measurement is made by the proximity detector, and in that the negative feedback device (14) acts upon vertical positioning means (10) for the substrate (2) in such a manner as to maintain a constant distance between the emitter and the surface of the support (9) which is located immediately beneath the end of the probe.

5. Microlithography device according to claim 4, characterised in that the treatment beam is a photon beam for photomechanical etching originating from a second light source (4) connected for this purpose to the probe (8) which constitutes the beam emitter.

6. Microlithography device according to claim 4 or 5, characterised in that the optical fibre (7) receives the light originating from the light source (5) of the proximity sensor (6) via a first optical coupler (11, 22), one input transmission channel (11a, 22a) of which is connected to the light source (5) and one output transmission channel (11c, 22c) of which is connected to the optical fibre (7), a third transmission channel (11b, 22b) being connected to the photodetector (13).

7. Microlithography device according to claim 6, characterised in that the coupler (11) is a first coupler, the input channel (11a) of which is connected to an output channel (12c) of a second coupler having a first input channel connected to the light source (5) of the proximity detector (6) and a second input channel (12a) connected to the second light source (4) which emits the treatment beam.

8. Microlithography device according to claim 4 or 6, characterised in that the treatment beam is an electron beam emitted by an emitter comprising a metallic layer (23) applied onto at least a proportion of the periphery of the probe (8) and connected to a conductive wire providing an electrical connection to an electrical supply (25), and in that the treatment electron beam is parallel to the beam of the probe (8) of the proximity sensor.

9. Microlithography device according to claim 8, characterised in that the metallic layer covers the entire periphery of the probe (8), the end of which is shaped into a point which is located at the same place as the light emitter used by the proximity sensor (6).

10. Microlithography device according to claim 9, characterised in that the output face of the fibre (7) of the probe (8) has no metallic layer.

11. Microlithography device according to claim 8, characterised in that the metallic layer is shaped as a semi-cylinder (23), the generating line of which is an arc of a circle (C) plotted around the fibre (7) of the probe (8).

12. Microlithography device according to claim 11, characterised in that the end face (27) of the probe (8) forms an angle of some degrees relative to the longitudinal direction of propagation of the beam in the fibre (7), such that the semi-cylinder (23) forms a point (28) directed towards the surface of the substrate.
